# EUROPÄISCHE PATENTANMELDUNG

(11) **EP 3 937 253 A1**
(43) Veröffentlichungstag der Anmeldung: **12.01.2022**
(21) Anmeldenummer: 21000175.6
(22) Anmeldetag: 01.07.2021
(51) Int. Cl.: H01L 29/06, H01L 29/08, H01L 29/205, H01L 29/417, H01L 29/423, H01L 29/737

(54) **VERTIKALER HOCHSPERRENDER III-V BIPOLARTRANSISTOR**

(30) Priorität: 06.07.2020 DE 102020004051
(71) Anmelder: AZUR SPACE Solar Power GmbH, 74072 Heilbronn (DE)
(72) Erfinder: Keller, Gregor, 74080 Heilbronn (DE); Wächter, Clemens, 74348 Lauffen am Neckar (DE); Fuhrmann, Daniel, 74081 Heilbronn (DE)
(74) Vertreter: Koch Müller Patentanwaltsgesellschaft mbH

(57) **Zusammenfassung**

Vertikaler hochsperrender III-V-Heteroübergang-Bipolartransistor (HBT) mit einem Emitter (20), einer Basis (16) und ein em Kollektor (12, 14, QLS, SUB), wobei der Emitter einen hochdotierten Emitterhalbleiterkontaktbereich (Ek) von einem ersten Leitfähigkeitstyp mit einer Dotierstoffkonzentration größer als 1•10¹⁸ N/cm³ aufweist, die Basis einen niedrigdotierten Basishalbleiterbereich (16) mit einer Dotierstoffkonzentration zwischen 1•10¹⁵ N/cm⁻³ und 1•10¹⁷ N/cm⁻³ und von einem zweiten Leitfähigkeitstyp aufweist, der Kollektor einen schichtförmigen niedrigdotierten Kollektorhalbleiterbereich (12) von dem ersten Leitfähigkeitstyp und mit einer Schichtdicke größer als 10 µm aufweist, der Kollektor einen schichtförmigen hochdotierten Kollektorhalbleiterkontaktbereich (QLS) von dem ersten Leitfähigkeitstyp aufweist, wobei die vorgenannten Halbleiterbereiche und Halbleiterkontaktbereiche in der genannten Reihenfolge angeordnet sind, eine gebietsweise ausgebildete erste metallische Anschlusskontaktschicht (K_E) stoffschlüssig mit dem Emitters verbunden ist, eine gebietsweise ausgebildete zweite metallische Anschlusskontaktschicht (K_B) stoffschlüssig mit der Basis verbunden ist, eine zumindest gebietsweise ausgebildete dritte metallische Anschlusskontaktschicht (K_K) unterhalb des Kollektors angeordnet ist, zumindest der Emitterhalbleiterkontaktbereich, der Basishalbleiterbereich und der Kollektorhalbleiterbereich jeweils ein III-V- Material umfassen oder aus einem III-V-Material bestehen.

## Beschreibung

Die Erfindung betrifft einen vertikalen hochsperrenden III-V-Bipolartransistor.

In der Leistungselektronik, insbesondere wenn Spannungen größer 400V gehandhabt werden müssen, werden als Schalter üblicherweise Tyristoren oder IGBTs auf Basis von Silizium oder Siliziumcarbid genutzt.

III-V-Halbleiter, insbesondere Galliumarsenid, werden dagegen auf Grund der höheren Ladungsträgermobilität im Allgemeinen für geringe Sperrspannungen unter 20 V für die Hochfrequenztechnik in Bereichen oberhalb 5 GHz genutzt.

Aus "Generation 2 High Voltage Heterojunction Bipolar Transistor Technology for High Efficiency Base Station Power Amplifiers", T. Landon et al., 2010 IE-EE MTT-S International Microwave Symposium, CD-ROM ISBN: 978-1-4244-7732-6, DOI: 10.1109/MWSYM.2010.5514779, ist beispielsweise ein Heteroübergang-Bipolartransistor für eine Arbeitsfrequenz von 2,1 GHz und mit einem InGaP/GaAs-Übergang und einer Betriebsspannung von 32 V bekannt. Die Basis-Kollektor Durchbruchsspannung konnte auf 85 V erhöht werden. Solche Bipolartransistoren werden vorzugsweise in Mobilfunkbasisstationen für Doherty Anwendungen eingesetzt.

Aus der EP 0 603 737 A2 sind IGBT mit einer besonders großen Bandlücke auf GaN-Basis bekannt. Aus der WO 2018 / 049339 A1 ist eine Super Beta HBT offenbart, mit einem Kollektor-Schichtaufbau unterhalb der Basis.

Aus der US 2015 / 0 014 706 A1 sind IGBTs mit hybrid bipolar / Feldeffekt Transistoren bekannt.

Vor diesem Hintergrund besteht die Aufgabe der Erfindung darin, eine Vorrichtung anzugeben, die den Stand der Technik weiterbildet.

Die Aufgabe wird durch einen vertikalen hochsperrenden III-V-Bipolartransistor mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein vertikaler hochsperrender III-V-Bipolartransistor mit einem Emitter, einer Basis und einem Kollektor bereitgestellt.

Der Emitter weist einen hochdotierten Emitterhalbleiterkontaktbereich von einem ersten Leitfähigkeitstyp mit einer Dotierstoffkonzentration größer als 1•10¹⁸ cm⁻³ und einer ersten Gitterkonstanten auf.

Die Basis weist einen niedrigdotierten Basishalbleiterbereich von einem zweiten Leitfähigkeitstyp und der ersten Gitterkonstanten auf.

Der Kollektor einen schichtförmigen niedrigdotierten Kollektorhalbleiterbereich von dem ersten Leitfähigkeitstyp mit einer Schichtdicke größer als 10 µm und der ersten Gitterkonstanten aufweist.

Außerdem weist der Kollektor einen schichtförmigen hochdotierten Kollektorhalbleiterkontaktbereich von dem ersten Leitfähigkeitstyp mit einer Dotierstoffkonzentration größer als 1•10¹⁸ cm⁻³.

Die vorgenannten Halbleiterbereiche und Halbleiterkontaktbereiche sind in der genannten Reihenfolge angeordnet.

Eine gebietsweise ausgebildete erste metallische Anschlusskontaktschicht ist stoffschlüssig mit dem Emitter und eine gebietsweise ausgebildete zweite metallische Anschlusskontaktschicht ist stoffschlüssig mit der Basis verbunden.

Des Weiteren ist eine zumindest gebietsweise ausgebildete dritte metallische Anschlusskontaktschicht unterhalb des Kollektors angeordnet, um den Kollektor elektrisch anzuschließen.

Der Emitterhalbleiterkontaktbereich, der Basishalbleiterbereich und der Kollektorhalbleiterbereich umfassen jeweils ein III-V- Material oder bestehen aus einem III-V-Material.

Es versteht sich, dass die metallischen Anschlusskontaktschichten vollständig oder teilweise aus einem Metall, z.B. Au und oder Pd und oder Ge, insbesondere aus einer Legierung bestehen.

Die Halbleiterbereiche und Halbleiterkontaktbereiche sind bevorzugt teilweise oder vollständig epitaktisch, z.B. mittels MOVPE oder mittel LPE, erzeugt.

Es sei angemerkt, dass mit dem Ausdruck III-V Material eine Verbindung aus III-V Elementen verstanden wird.

Des Weiteren sei angemerkt, dass mit dem Ausdruck "niedrig" dotierten Basisbereich eine Konzentration der Dotierstoffe in einem Bereich zwischen 1•10¹⁵ cm⁻³ und 1•10¹⁷ cm⁻³ verstanden wird. Vorzugsweise weist die Basis eine Dicke zwischen 0,1 µm und 5µm, oder in einem Bereich zwischen 0,2 µm und 0,5 µm auf. In einer Weiterbildung weist die Basis einen Gradienten im Dotierstoffverlauf auf. Hierbei ist der Gradient vorzugsweise stetig ausgebildet. Es versteht sich, dass bei Ausbildung eines Dotierstoffgradienten in der Basis die emitterseitige Dotierung der Basisschicht größer ist als die kollektorseitige Dotierung der Basisschicht.

Es versteht sich, dass ein aus einem III-V-Material, insbesondere aus GaAs oder aus AlGaAs oder aus InGaAs oder aus AlInGaAs oder aus InGaP oder aus AlInGaAs bestehender Halbleiterbereich oder Halbleiterkontaktbereich neben den vorgenannten III-V-Materialien zusätzlich immer auch Dotierstoffe in einem Bereich zwischen 1•10¹² cm⁻³ und 5•10²⁰ cm⁻³ aufweist. Auch sei angemerkt, dass die Halbleiterkontaktbereiche und die Halbleiterbereiche auch Verunreinigungen wie beispielsweise O aufweisen können.

Des Weiteren versteht es sich, dass mit dem Ausdruck "umfasst ein III-V-Material" der jeweilige Halbleiterbereich oder der jeweilige Halbleiterkontaktbereich neben III-V Verbindungen wie GaAs oder AlGaAs oder InGaAs oder AlInGaAs oder InGaP oder AlInGaAs auch weitere Elemente aus der III-V Gruppe insbesondere Al, P, In aufweisen können.

Ein Vorteil ist es, dass mittels des mindestens 10 µm dicken, niedrig dotierten Kollektorhalbleiterbereichs eine hohe Betriebsspannung oberhalb 50 V und eine hohe Basis Kollektor Durchbruchspannung oberhalb von 200 V erreichen lässt mit einer Grenzfrequenz oberhalb von 1 GHZ. Anders ausgedrückt, der überwiegende Teil der Raumladungszone erstreckt sich in den Teil des niedrig dotierten Kollektorhalbleiterbereich.

Ein anderer Vorteil ist, dass sich der Kollektor von der Rückseite anschließen lässt. Insbesondere bei einer ganzflächigen Ausbildung der dritten metallischen Anschlusskontaktschicht lässt sich ein geringerer Anschlusswiderstand erzielen. In einer Ausführungsform lässt sich die thermische Ankopplung wesentlich verbessern, indem die dritte metallische Anschlusskontaktschicht unmittelbar auf einem metallischen Träger stoffschlüssig angeordnet wird.

Überraschenderweise hat sich gezeigt, dass sich ein vertikaler hochsperrender Transistor mit hoher Schaltfrequenz zuverlässig und kostengünstig ausbilden lässt. Insbesondere zeigte sich, dass es bisher im Unterschied zu den Siliziumbauelementen die technologischen Herausforderungen bei den III-V Verbindungen völlig unterschiedlich sind, so dass eine Übertragung der Bauelementstrukturen von den Silizium auf III-V als nicht durchführ sind.

In einer ersten Ausführungsform weist der Emitter eine hochdotierte Emitterzwischenschicht von dem ersten Leitfähigkeitstyp auf. Die Emitterzwischenschicht ist zwischen dem Emitterhalbleiterkontaktbereich und dem Basishalbleiterbereich angeordnet ist und weist eine Dotierstoffkonzentration größer als 1•10¹⁸ N/cm³ und eine erste Bandlückenenergie auf. Der Basishalbleiterbereich weist eine zweite Bandlückenenergie auf, wobei die erste Bandlückenenergie größer als die zweite Bandlückenenergie ist.

Durch die Heterobarriere zwischen Basis und Emitter wird ein Basis-Emitter Löcherstrom unterdrückt und hierdurch die Verstärkung des Transistors erhöht. Die Barriere führt zu einer um einen Faktor exp(-ΔE_{g}/kT) größeren Verstärkung. Solche Heterostruktur Bipolartransistoren (HBT) werden daher auch Super Beta HBT bezeichnet. Hierdurch lässt sich die Dotierung der Basis zu erhöhen und die Schaltgeschwindigkeit erhöhen. Es versteht sich, dass sich die Verstärkung aus dem Verhältnis von Elektronenstrom injiziert von dem Emitter in die Basis zu Löcherstrom injiziert von Basis in den Emitter ergibt.

In einer zweiten Ausführungsform weist der Kollektor eine hochdotierte Kollektorzwischenschicht von dem zweiten Leitfähigkeitstyp auf, wobei die Kollektorzwischenschicht zwischen dem Basishalbleiterbereich und dem Kollektorhalbleiterbereich angeordnet ist, eine Dotierstoffkonzentration kleiner als 5•10¹⁷ cm⁻³ und eine dritte Bandlückenenergie aufweist, der Basishalbleiterbereich eine zweite Bandlückenenergie aufweist und die dritte Bandlückenenergie größer als die zweite Bandlückenenergie ist. In einer Weiterbildung ist die Kollektorzwischenschicht zwischen dem Basishalbleiterbereich und dem Kollektorhalbleiterbereich angeordnet und weist eine Dotierstoffkonzentration kleiner als 1•10¹⁷ cm^{-3.} auf. Vorzugsweise ist die Dotierstoffkonzentration der Kollektorzwischenschicht größer als 1•10¹⁴ cm⁻³, oder größer als 1•10¹⁵ cm⁻³

Der Heteroübergang zwischen Kollektor und Basis verhindert das Auftreten von Löcherinjektion von der Basis in den Kollektor und führt entsprechend ebenfalls zu einer Steigerung der Verstärkung.

Durch ein Kombination des Heteroübergangs zwischen Basis und Kollektor mit dem Heteroübergang zwischen der Basis und dem Emitter wird ein sogenannter Dual Junction HBT, also ein HBT mit zwei Heteroübergängen ausgebildet, der insbesondere den vorbeschriebenen Vorteil hoher Schaltgeschwindigkeiten aufweist.

Gemäß einer Weiterbildung umfasst der Basishalbleiterbereich GaAs oder besteht aus GaAs und die Emitterzwischenschicht und/oder die Kollektorzwischenschicht umfasst InGaP oder AlGaAs oder besteht aus InGaP oder aus AlGaAs.

Gemäß einer anderen Ausführungsform ist der Kollektorhalbleiterkontaktbereich als Substratschicht ausgebildet.

In einer weiteren Ausführungsform umfasst der Bipolartransistor einen Halbleitersubstratbereich, wobei der Halbleitersubstratbereich zwischen der dritten metallischen Anschlusskontaktschicht und dem Kollektorhalbleiterkontaktbereich angeordnet ist.

In einer anderen Weiterbildung umfasst der Bipolartransistor eine metamorphe Pufferschichtfolge von dem ersten Leitfähigkeitstyp mit einer Schichtdicke oberhalb 0,5 µm und kleiner als 20 µm, wobei die metamorphe Pufferschichtfolge eine Oberseite mit der ersten Gitterkonstante und eine Unterseite mit einer zweiten Gitterkonstante aufweist, zwischen dem Kollektorhalbleiterbereich und dem Kollektorhalbleiterkontaktbereich oder unterhalb des Kollektorhalbleiterkontaktbereichs angeordnet ist oder als Kollektorhalbleiterkontaktbereich ausgebildet ist.

Es versteht sich, dass alle oberhalb der metamorphen Pufferschichtfolge angeordneten Halbleiterbereiche weisen die erste Gitterkonstante aufweisen und alle unterhalb der metamorphen Pufferschichtfolge angeordneten Halbleiterbereiche die zweite Gitterkonstante und den ersten Leitfähigkeitstyp aufweisen.

Gemäß einer weiteren Ausführungsform ist der erste Leitfähigkeitstyp p und der zweite Leitfähigkeitstyp n oder der erste Leitfähigkeitstyp ist n und der zweite Leitfähigkeitstyp ist p. Hierdurch lassen sich sowohl vertikale pnp- als auch vertikale npn-Strukturen ausbilden.

In einer weiteren Ausführungsform ist zumindest der Emitter als Mesa-Struktur mit einer ersten Höhe H1 auf einer Oberfläche der Basis ausgebildet. Die Mesa-Struktur ist beispielsweise mittels eines Ätzprozesses entstanden.

Gemäß einer Weiterbildung weist dass der Bipolartransistor einen Halbleiterrandbereich mit einer Breite B und einer zweiten Höhe H2 aufweist, wobei der Randbereich sich entlang des Rands der Oberfläche der Basis um den Emitter, die erste Anschlusskontaktschicht und die zweite Anschlusskontaktschicht herum erstreckt, die zweite Höhe H2 des Halbleiterrandbereich kleiner oder gleich der ersten Höhe H1 des Emitter ist und der Halbleiterrandbereich entlang der zweiten Höhe H2 ein dem Emitter entsprechendes Material aufweist.

Der Randbereich entspricht also entlang seiner Höhe dem Emitter bis zu dieser Höhe, d.h. der Randbereich besteht entlang der Höhe immer aus demselben Material oder Materialverlauf wie der Emitter.

Umfasst der Emitter beispielsweise eine Emitterzwischenschicht und die Emitterhalbleiterkontaktbereich, so besteht der Randbereich gemäß einer ersten Ausführungsform aus einem der Emitterzwischenschicht entsprechenden Material und weist eine der Schichtdicke der Emitterzwischenschicht entsprechende Schichtdicke auf. Gemäß einer zweiten Ausführungsform weist der Randbereich ebenfalls zwei Schichten auf, wobei die an die Oberfläche der Basis angrenzende erste Schicht ein der Emitterzwischenschicht entsprechendes Material und die folgende zweite Schicht ein dem Emitterhalbleiterkontaktbereich entsprechendes Material aufweist.

Der Halbleiterrandbereich ist beispielsweise auf einfache Weise gemeinsam mit dem Emitter durch einen Ätzprozess aus einer gemeinsamen Ausgangsschicht erzeugt.

Der sich geländerartig/balkonartig entlang des Rands erstreckende Halbleiterrandbereich dient zur Kantenpassivierung.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Querschnittsansicht einer ersten Ausführungsform eines vertikalen hochsperrenden III-V-Bipolartransistors,
- Figur 2: eine Querschnittsansicht einer zweiten erfindungsgemäßen Ausführungsform eines vertikalen hochsperrenden III-V-Bipolartransistors,
- Figur 3: eine Querschnittsansicht einer dritten Ausführungsform eines vertikalen hochsperrenden III-V-Bipolartransistors,
- Figur 4: eine Querschnittsansicht einer vierten Ausführungsform eines vertikalen hochsperrenden III-V-Bipolartransistors,
- Figur 5: eine Querschnittsansicht einer fünften Ausführungsform eines vertikalen hochsperrenden III-V-Bipolartransistors,
- Figur 6: eine Querschnittsansicht einer sechsten Ausführungsform eines vertikalen hochsperrenden III-V-Bipolartransistors,
- Figur 7: eine Draufsicht auf eine Ausführungsform eines vertikalen hochsperrenden III-V-Blpolartransistors,
- Figur 8: eine Draufsicht auf eine Ausführungsform eines vertikalen hochsperrenden III-V-Bipolartransistors,
- Figur 9: eine Draufsicht auf eine Ausführungsform eines vertikalen hochsperrenden III-V-Bipolartransistors,
- Figur 10: eine Draufsicht auf eine Ausführungsform eines vertikalen hochsperrenden III-V-Bipolartransistors,
- Figur 11: eine Draufsicht auf eine Ausführungsform eines einzelnen vertikalen hochsperrenden III-V-Bipolartransistors,
- Figur 12: eine Querschnittsansicht auf die Ausführungsform eines einzelnen vertikalen hochsperrenden III-V-Bipolartransistors, dargestellt in der Figur 11, entlang der Linie A - A'.

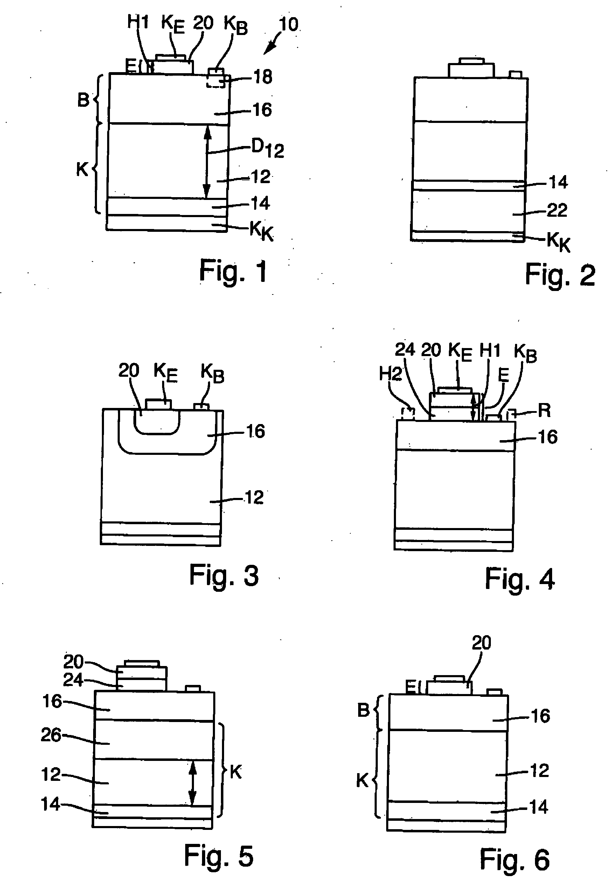

Die Abbildung der Figur 1 zeigt eine erste Ausführungsform eines vertikalen hochsperrenden III-V-Bipolartransistor 10 mit einem Kollektor K, einem Emitter E und einer Basis B und drei Anschlusskontaktschichten K_{K}, K_{E} und K_{B}.

Der Kollektor umfasst einen niedrig n-dotierten Kollektorhableiterbereich 12 und einen hoch n-dotierten Kollektorhalbleiterbereich 14 auf, wobei der Kollektorhalbleiterbereich 12 mit einer Unterseite auf einer Oberseite des Kollektorhalbleiterkontaktbereichs 14 angeordnet ist und die dritte Anschlusskontaktschicht K_{K} die Unterseite des 14 bedeckt. Der Kollektorhalbleiterbereich 12 weist eine Dicke D12 von mindestens 10 µm auf.

Die Basis B umfasst einen niedrig p-dotierten Basishalbleiterbereich 16, wobei der Basishalbleiterbereich 16 mit einer Unterseite auf einer Oberseite des Kollektorhalbleiterbereichs 12 angeordnet ist. Auf einem ersten Teilbereich einer Oberseite des Basishalbleiterbereichs 16 ist die zweite Anschlusskontaktschicht K_{B} angeordnet, wobei sich gemäß einer Weiterbildung ein hoch p-dotierter Basishalbleiterkontaktbereich 18 (gestrichelt dargestellt) zumindest von dem ersten Teilbereich der Oberseite des Basishalbleiterbereichs 16 wannenförmig in den Basishalbleiterbereich 16 hinein erstreckt.

Auf einem zweiten Teilbereich der Oberseite des Basishalbleiterbereichs 16 ist ein den Emitter E als Mesa-Struktur mit einer ersten Höhe H1 ausbildender, hoch n-dotierter Emitterhalbleiterkontaktbereich 20 angeordnet. Auf einer Oberseite des Emitterhalbleiterkontaktbereichs 20 ist die erste Anschlusskontaktschicht ausgebildet.

Der Transistor 10 weist hierdurch eine npn-Struktur auf und ist stapelförmig mit schichtförmigen Halbleiterbereichen und Halbleiterkontaktbereichen ausgebildet, wobei der Emitter E einen geringeren Durchmesser als Basis und Kollektor aufweist, und als Mesa Emitter ausgebildet ist. Es versteht sich, dass sich ebenfalls eine pnp-Struktur ausbilden lässt.

In der Abbildung der Figur 2 ist eine zweite Ausführungsform dargestellt. Im Folgenden werden nur die Unterschiede zu der Abbildung der Figur 1 erläutert.

Der vertikale hochsperrende III-V-Halbleitertransistor weist eine weitere Halbleiterschichtstruktur 22 auf, wobei die weitere Halbleiterschichtstruktur 22 zwischen der Unterseite des Kollektorhalbleiterkontaktbereichs 14 und dritten Anschlusskontaktschicht K_{K} angeordnet ist.

Die weitere Halbleiterschichtstruktur 22 umfasst ein Substrat bzw. einen Halbleitersubstratbereich und/oder einen metamorphen Puffer bzw. eine metamorphe Pufferschichtfolge.

In der Abbildung der Figur 3 ist eine dritte Ausführungsform dargestellt. Im Folgenden werden nur die Unterschiede zu der Abbildung der Figur 1 erläutert.

Basis und Emitter sind wannenförmig ausgebildet, so dass sich von einer Oberseite des Transistors 10 der Basishalbleiterbereich 16 in den Kollektorhalbleiterbereich 12 und der Emitterhalbleiterbereich 20 in den Basishalbleiterbereich 16 erstreckt.

In der Abbildung der Figur 4 ist eine vierte Ausführungsform dargestellt. Im Folgenden werden nur die Unterschiede zu der Abbildung der Figur 1 erläutert.

Der vertikale hochsperrende III-V-Bipolartransistor 10 ist als Heteroübergang Bipolartransistor ausgebildet, wobei eine an den Basishalbleiterbereich 16 angrenzende Emitterzwischenschicht 24 des Emitters aus einem Material mit einer ersten Bandlückenenergie ausgebildet ist und die erste Bandlückenenergie größer als eine zweite Bandlückenenergie des Basishalbleiterbereichs 16 ist. Die Emitterzwischenschicht 24 ist zwischen dem Basishalbleiterbereich 16 und dem Emitterhalbleiterkontaktbereich 20 angeordnet.

In einer Weiterbildung umfasst der vertikale hochsperrende III-V-Bipolartransistor 10 einen Halbleiterrandbereich R mit einer Breite B und einer Höhe H2 auf, wobei der Halbleiterrandbereich R auf der Oberfläche der Basis B angeordnet ist, sich entlang eines Rands der Oberfläche balkonartig um den Emitter E, die erste Anschlusskontaktschicht K_{E} und die zweite Anschlusskontaktschicht K_{B} herum erstreckt. Die Höhe H2 des Randbereichs R ist kleiner als die Höhe H1 des Emitters E und entspricht einer Schichtdicke der Emitterzwischenschicht 24, wobei das Material des Halbleiterrandbereichs R dem Material der Emitterzwischenschicht 24 entspricht.

In der Abbildung der Figur 5 ist eine fünfte Ausführungsform dargestellt. Im Folgenden werden nur die Unterschiede zu der Abbildung der Figur 4 erläutert.

Zusätzlich zu dem ersten Heteroübergang zwischen der Emitterzwischenschicht 24 und dem Basishalbleiterbereich 16 weist der Bipolartransistor 10 einen zweiten Heteroübergang zwischen dem Basishalbleiterbereich 16 und einer Kollektorzwischenschicht 26 des Kollektors K auf, wobei die Kollektorzwischenschicht 26 aus einem Material mit einer dritten Bandlückenenergie besteht und die dritte Bandlückenenergie größer als die zweiten Bandlückenenergie des Basishalbleiterbereichs 16 ist. Die Kollektorzwischenschicht 26 ist zwischen dem Basishalbleiterbereich 16 und dem Kollektorhalbleiterbereich 12 mit der Schichtdicke D12 angeordnet.

In der Abbildung der Figur 6 ist eine sechste Ausführungsform dargestellt. Im Folgenden werden nur die Unterschiede zu der Abbildung der Figur 1 erläutert.

Der Bipolartransistor 10 ist als npn-Transistor ausgebildet. Der Kollektorhalbleiterkontaktbereich 14 und der Emitterhalbleiterkontaktbereich 20 sind hoch n-dotiert, der Kollektorhalbleiterbereich 12 ist schwach n-dotiert und der Basishalbleiterbereich 16 ist schwach p-dotiert ausgebildet.

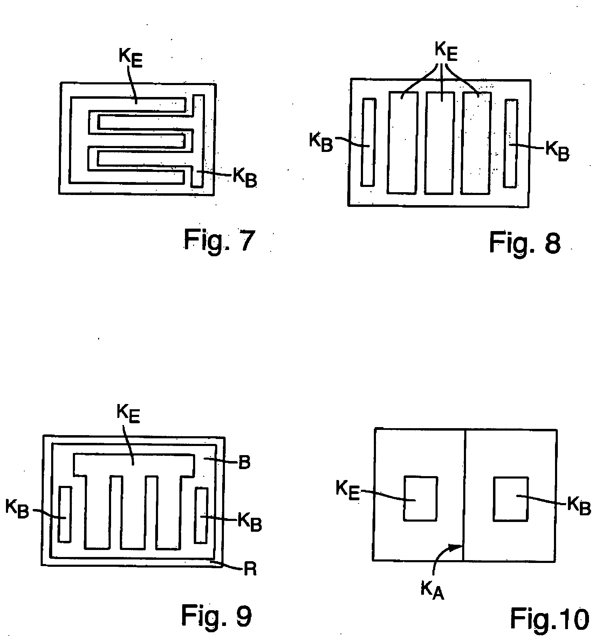

In der Abbildung der Figur 7 ist eine Aufsicht auf eine weitere Ausführungsform des vertikalen hochsperrenden III-V-Bipolartransistors dargestellt. Die erste Anschlusskontaktschicht K_{E} weist mehrere durch eine Längsrippe verbundene Querrippen auf. Die zweite Anschlusskontaktschicht K_{B} weist ebenfalls durch eine Längsrippe verbundene Querrippen auf, wobei die Querrippen der zweiten Anschlusskontaktschicht K_{B} in Zwischenräume zwischen den Querrippen der ersten Anschlusskontaktschicht K_{E} hineinreichen.

In der Abbildung der Figur 8 ist eine Aufsicht auf eine weitere Ausführungsform des vertikalen hochsperrenden III-V-Bipolartransistors dargestellt. Im Folgenden werden nur die Unterschiede zu der Abbildung der Figur 7 erläutert.

Die erste Anschlusskontaktschicht K_{E} umfasst drei parallel verlaufende Rippen. Die zweite Anschlusskontaktschicht E_{B} umfasst zwei Rippen, wobei die zwei Rippen der zweiten Anschlusskontaktschicht E_{B} links und rechts neben den Rippen der ersten Anschlusskontaktschicht K_{E} angeordnet sind.

In der Abbildung der Figur 9 ist eine Aufsicht auf eine weitere Ausführungsform des vertikalen hochsperrenden III-V-Bipolartransistors dargestellt. Im Folgenden werden nur die Unterschiede zu der Abbildung der Figur 7 erläutert.

Die erste Anschlusskontaktschicht K_{E} umfasst mehrere durch eine Querrippe verbundene Längsrippen. Die zweite Anschlusskontaktschicht K_{B} umfasst zwei Rippen, wobei die zwei Rippen der zweiten Anschlusskontaktschicht K_{B} links und rechts neben den Längsrippen der ersten Anschlusskontaktschicht K_{E} angeordnet sind.

Der Halbleiterrandbereich R erstreckt sich entlang des Randes der Oberfläche der Basis B.

In der Abbildung der Figur 10 ist eine Aufsicht auf eine weitere Ausführungsform des vertikalen hochsperrenden III-V-Bipolartransistors dargestellt. Im Folgenden werden nur die Unterschiede zu der Abbildung der Figur 7 erläutert.

Sowohl die erste Anschlusskontaktschicht KE als auch die zweite Anschlusskontaktschicht K_{B} umfassen jeweils genau eine Kontaktfläche, wobei die Kontaktflächen in der dargestellten Aufsicht jeweils auf einer Seite einer die Oberseite des III-V-Bipolartransistors teilenden und beispielsweise durch einen Ätzprozess entstandenen Stufe KA liegen.

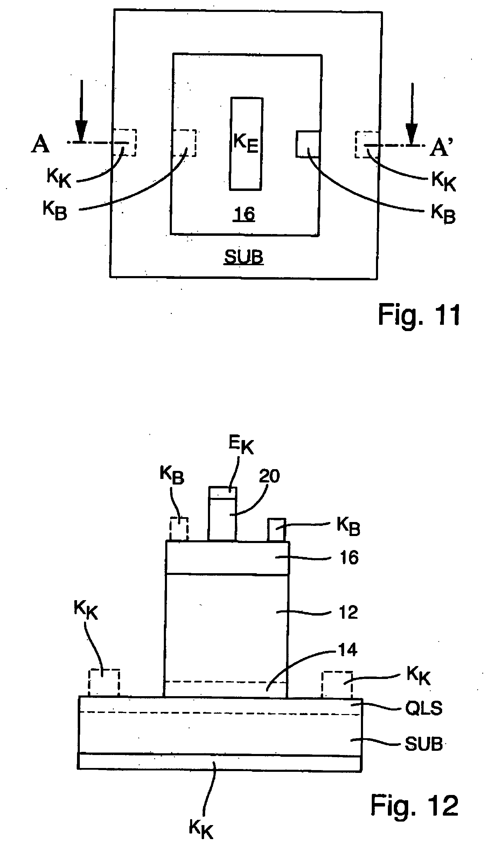

In der Abbildung der Figur 11 ist eine Aufsicht auf eine Ausführungsform eines einzelnen vertikalen hochsperrenden III-V-Bipolartranslstors dargestellt. Im Folgenden werden nur die Unterschiede zu der Abbildung der Figur 9 erläutert.

Bei dem Emitter ist die erste Anschlusskontaktschicht K_{E} mit dem Emitterhalbleiterkontaktbereich 20 stoffschlüssig verbunden. Der Emitter umfasst nur eine Längsrippe und ist von dem Basishalbleiterbereich 16 vollständig umschlossen. Der Basishalbleiterbereich 16 ist mittels der zweiten Anschlusskontaktschicht K_{B} elektrisch angeschlossen. Optional weist der Basishalbleiterbereich 16 einen weiteren zweiten Anschlusskontaktschicht K_{B} - gestrichelt eingezeichnet auf, um das dynamische Verhalten der Transistorstruktur zu verbessern. Der Basishalbleiterbereich 16 ist von einer Substratschicht SUB vollständig umschlossen. Optional ist auf der Substratschicht SUB einen niederohmige Schicht ausgebildet, wobei die niederohmige Schicht mittels einer hohe Querleitfähigkeit ermöglicht, den Kollektorhalbleiterbereich 12 optional mittels dritten Anschlusskontaktschichten K_{K} - gestrichelt eingezeichnet- anzuschließen. Hierdurch lassen sich die dynamischen Eigenschaften des Transistors weiter verbessern.

In der Abbildung der Figur 12 ist eine Querschnittsansicht auf die Ausführungsform des vertikalen hochsperrenden III-V-Bipolartransistors, dargestellt in der Figur 11, entlang der Linie A - A' abgebildet. Im Folgenden werden nur die Unterschiede zu der Abbildung der Figur 11 erläutert.

Die Transistorstruktur ist als Mesa-Struktur ausgebildet und weist eine Stufe durch die umlaufende Substratschicht SUB auf. Optional weist der Kollektor an der Unterseite einen Kollektorhalbleiterkontaktbereich 14 auf. Sofern keine Querleitschicht QLS und keine Kollektorhalbleiterkontaktbereich 14 zwischen Kollektor und der Substratschicht ausgebildet sind, liegt der Kollektorhalbleiterkontaktbereich 12 unmittelbar auf der Substratschicht SUB auf. Hierbei ist der Kollektor durch die Substratschicht angeschlossen. Die Substratschicht weist an der Unterseite hierzu eine dritte vorzugsweise ganzflächig ausgebildete dritte Anschlusskontaktschicht K_{K} auf.

## Patentansprüche

1. Vertikaler hochsperrender III-V-Bipolartransistor (10) mit einem Emitter (E), einer Basis (B) und einem Kollektor (K), wobei
- der Emitter (E) einen hochdotierten Emitterhalbleiterkontaktbereich (20) von einem ersten Leitfähigkeitstyp mit einer Dotierstoffkonzentration größer als 1•10¹⁸ cm⁻³ und einer ersten Gitterkonstanten aufweist,
- die Basis (B) einen niedrigdotierten Basishalbleiterbereich (16) von einem zweiten Leitfähigkeitstyp und der ersten Gitterkonstanten aufweist,
- der Kollektor (K) einen schichtförmigen niedrigdotierten Kollektorhalbleiterbereich (12) von dem ersten Leitfähigkeitstyp mit einer Schichtdicke größer als 10 µm und der ersten Gitterkonstanten aufweist,
- der Kollektor (K) einen schichtförmigen hochdotierten Kollektorhalbleiterkontaktbereich (14) von dem ersten Leitfähigkeitstyp mit einer Dotierstoffkonzentration größer als 1•10¹⁸ cm⁻³, wobei
- die vorgenannten Halbleiterbereiche (12, 16) und Halbleiterkontaktbereiche (14, 20) in der genannten Reihenfolge angeordnet sind,
- eine gebietsweise ausgebildete erste metallische Anschlusskontaktschicht (K_{E}) stoffschlüssig mit dem Emitter verbunden ist,
- eine gebietsweise ausgebildete zweite metallische Anschlusskontaktschicht(K_{B}) stoffschlüssig mit der Basis (B) verbunden ist,
- eine zumindest gebietsweise ausgebildete dritte metallische Anschlusskontaktschicht (K_{K}) unterhalb des Kollektors (K) angeordnet ist,
- der Emitterhalbleiterkontaktbereich (20), der Basishalbleiterbereich (16) und der Kollektorhalbleiterbereich (12) jeweils ein III-V- Material umfassen oder aus einem III-V-Material bestehen,

2. Vertikaler III-V-Bipolartransistor (10) nach Anspruch 1, **dadurch gekennzeichnet, dass** der Emitter (E) eine hochdotierte Emitterzwischenschicht (24) von dem ersten Leitfähigkeitstyp aufweist, wobei die Emitterzwischenschicht (24) zwischen dem Emitterhalbleiterkontaktbereich (20) und dem Basishalbleiterbereich (16) angeordnet ist, eine Dotierstoffkonzentration größer als 1•10¹⁸ cm⁻³ und eine erste Bandlückenenergie aufweist, der Basishalbleiterbereich (16) eine zweite Bandlückenenergie aufweist und die erste Bandlückenenergie größer als die zweite Bandlückenenergie ist.

3. Vertikaler III-V-Bipolartransistor (10) nach einem der vorstehenden Ansprüche, **dadurch gekennzeichnet, dass** der Kollektor (K) eine Kollektorzwischenschicht (26) von dem zweiten Leitfähigkeitstyp aufweist, wobei die Kollektorzwischenschicht (26) zwischen dem Basishalbleiterbereich (16) und dem Kollektorhalbleiterbereich (12) angeordnet ist, eine Dotierstoffkonzentration kleiner als 5•10¹⁷ cm⁻³ und eine dritte Bandlückenenergie aufweist, der Basishalbleiterbereich (16) eine zweite Bandlückenenergie aufweist und die erste Bandlückenenergie größer als die dritte Bandlückenenergie ist.

4. Vertikaler III-V-Bipolartransistor (10) nach Anspruch 2 oder 3, dass der Basishalbleiterbereich (16) GaAs umfasst oder aus GaAs besteht und die Emitterzwischenschicht (24) und/oder die Kollektorzwischenschicht (26) GaAs oder InGaP oder AlGaAs umfasst oder aus InGaP oder aus GaAs oder aus AlGaAs besteht.

5. Vertikaler III-V-Bipolartransistor (10) nach einem der vorstehenden Ansprüche, **dadurch gekennzeichnet, dass** der Kollektorhalbleiterkontaktbereich (14) als Substratschicht ausgebildet ist.

6. Vertikaler III-V-Bipolartransistor (10) nach einem der vorstehenden Ansprüche, **dadurch gekennzeichnet, dass** der Bipolartransistor (10) einen Halbleitersubstratbereich umfasst, wobei der Halbleitersubstratbereich zwischen der dritten metallischen Anschlusskontaktschicht (K_{K}) und dem Kollektorhalbleiterkontaktberelch (14) angeordnet ist.

7. Vertikaler III-V-Bipolartransistor (10) nach einem der vorstehenden Ansprüche, **dadurch gekennzeichnet, dass** der Bipolartransistor (10) eine metamorphe Pufferschichtfolge von dem ersten Leitfähigkeitstyp mit einer Schichtdicke oberhalb 0,5 µm und kleiner als 20 µm umfasst, wobei die metamorphe Pufferschichtfolge eine Oberseite mit der ersten Gitterkonstante und eine Unterseite mit einer zweiten Gitterkonstante aufweist und die metamorphe Pufferschichtfolge zwischen dem Kollektorhalbleiterbereich und dem Kollektorhalbleiterkontaktbereich oder unterhalb des Kollektorhalbleiterkontaktbereichs angeordnet ist oder als Kollektorhalbleiterkontaktbereich ausgebildet ist, wobei alle unterhalb der metamorphen Pufferschichtfolge angeordneten Halbleiterbereiche die zweite Gitterkonstante und den ersten Leitfähigkeitstyp aufweisen.

8. Vertikaler III-V-Bipolartransistor (10) nach einem der vorstehenden Ansprüche, **dadurch gekennzeichnet, dass** der erste Leitfähigkeitstyp p und der zweite Leitfähigkeitstyp n ist oder der erste Leitfähigkeitstyp n und der zweite Leitfähigkeitstyp p ist.

9. Vertikaler III-V-Bipolartransistor (10) nach einem der vorstehenden Ansprüche, **dadurch gekennzeichnet, dass** zumindest der Emitter (E) als Mesa-Struktur mit einer ersten Höhe H1 auf einer Oberfläche der Basis (B) ausgebildet ist.

10. Vertikal III-V-Bipolartransistor (10) nach Anspruch 9, **dadurch gekennzeichnet, dass** der Bipolartransistor (10) einen Halbleiterrandbereich mit einer Breite B und einer zweiten Höhe H2 aufweist, wobei der Randbereich sich entlang des Rands der Oberfläche der Basis (B) um den Emitter, die erste Anschlusskontaktschicht und die zweite Anschlusskontaktschicht herum erstreckt, die zweite Höhe H2 des Halbleiterrandbereich kleiner oder gleich der ersten Höhe H1 des Emitter (E) ist und der Halbleiterrandbereich entlang der zweiten Höhe H2 ein dem Emitter (E) entsprechendes Material aufweist.
